# EUROPEAN PATENT APPLICATION

(11) **EP 1 724 831 A2**
(43) Date of publication of application: **22.11.2006**
(21) Application number: 06009981.9
(22) Date of filing: 15.05.2006
(51) Int. Cl.: H01L 23/495

(54) **Lead-free semiconductor device**

(30) Priority: 16.05.2005 JP 2005143276
(71) Applicant: NEC Electronics Corporation, Kawasaki, Kanagawa 211-8668 (JP)
(72) Inventor: Nomura, Yukio, Nakahara-ku Kawasaki Kanagawa 211-8668 (JP)
(74) Representative: Glawe, Delfs, Moll

(57) **Abstract**

A an aspect of the present invention, a semiconductor device includes a lead frame having a lower base structure of oxygen free copper or copper-based alloy and having terminals; a semiconductor chip connected with the terminals of the lead frame; and a mold resin configured to cover the semiconductor chip. The lead frame has an exposed portion from the mold resin, and the exposed portion includes a diffusion prevention film formed on or above the lower base structure of the lead frame; and a Sn-Bi (tin-bismuth) film formed on the diffusion prevention film.

## Description

### Background of the Invention

### 1. Field of the Invention

The present invention relates to a semiconductor device and a method of manufacturing the same, under consideration of lead free.

### 2. Description of the Related Art

In semiconductor business activities, one of the most urgent targets is "lead-free" or "Pb-free" for environmental protection.

Electronic parts are jointed on a printed circuit board by solder of an alloy of Sn (tin) and Pb (lead). The printed circuit board is formed to have multi-function, and reduced in size, decreased in cost, and finally highly integrated. As a result, it is difficult to recycle the printed circuit board. Some printed circuit boards are recovered, but most printed circuit boards are crushed and buried as special industrial waste. The printed circuit boards thus buried include solder material applied thereto, and the solder material contains lead (Pb), which is turned into a water-soluble lead compound by acid rain. The lead compound contaminates groundwater, and there is a possibility that the contaminated groundwater enter in the human body as drinking water. It has been known for many years that lead is harmful to the human body.

In recent years, European countries are enforcing regulations on the use of chemical materials in end user products such as Waste Electrical and Electronic Equipment (WEEE), Restriction of the use of certain Hazardous Substances (RoHS), End-of-life Vehicles (ELV). Similarly, in the USA, a bill was proposed to restrict the use of lead in electronics (1990). Now, alternative solder materials are rapidly being developed at national and enterprise levels. Also, in Japan, Home Appliance Recycling Law and the Law Concerning the Examination and Regulation of Manufacture, etc. of Chemical Substances have been established. Global efforts for environment protection are being advanced. With the tightened regulations, there is a strong demand to remove harmful chemical substances from electric/electronic equipment and automobiles. In April 1997, Ministry of International Trade and Industry established numerical goals of the use (amount) of lead in automobiles excluding batteries, as "1/2 of that in 1996 by the end of 2000, and 1/3 of that of 1996 by the end of 2005." Since it was obliged to recover lead in 2001 by the Home Appliance Recycling Law, home appliance industries are actively trying to achieve lead-free products.

Along with these trends, lead-free semiconductor products are being promoted as part of environment protection activities. Conventional semiconductor devices are composed of a semiconductor chip, a mold resin and a lead frame, and the lead frame is plated with Sn-Pb (tin-lead). Also, when the semiconductor device is secondarily mounted on a printed circuit board in the semiconductor maker or a customer site, Pb-Sn solder is used. But now, in order to achieve lead-free products, plating material of the lead frame and the solder for the secondary mounting have been tried to be changed.

In conjunction with the above description, a semiconductor device is disclosed in Japanese Laid Open Patent Publication (JP-A-Heisei 11-354705). The semiconductor device has outer leads which extend outside from the package for sealing the semiconductor chip and which are connected with the semiconductor chip inside the package. The tip of the outer lead is partially coated with a material that can improve soldering characteristics.

In a TAB (Tape Automated Bonding) tape, a lower plating film made of a material selected from the group consisting of Ni, Co, Au, Ag, Pt, Pd and Rh is formed as a lower base film and a Sn plating film or a solder plating film is formed on the outer lead. The lower plating film can prevent Cu from diffusing into the Sn plating film even in a high temperature range of 400 to 500 °C for 2 seconds in a bonding process between the semiconductor chip and an inner lead. Thus, the lower plating film improves the soldering characteristics between the outer lead and an external conductive circuit.

Also, Japanese Laid Open Patent Publication (JP-A-Heisei 3-237735) discloses a TAB tape. In the TAB tape, a connection circuit pattern is made of copper or copper alloy, and a tin plating film or a solder plating film is formed on inner and outer leads. In the TAB tape, a lower base film for a tin plating film or a solder plating film is formed as a first plating film and a second plating film. The first plating film is formed on the outer leads, and the second plating film is formed on the first plating film. The first plating film is made of a material selected from the group consisting of nickel, cobalt, tin-nickel alloy, tin-cobalt alloy, nickel-cobalt alloy, and tin-nickel-cobalt alloy. The second plating film is made of a metal selected from the group consisting of gold, silver, platinum, palladium, and rhodium.

In the conventional technique disclosed in the above Japanese Laid Open Patent Publication (JP-A-Heisei 11-354705), a sufficient size of solder fillet can be formed between the outer lead portion and the printed circuit board. Since the sufficient size of solder fillet is formed, increase in the bonding strength of leads, prevention of short-circuit between wirings due to excess solder, and improvement in the efficiency and precision of a testing process are achieved.

In this conventional technique, however, when the plating is carried out with sn-containing solder, diffusion of Sn and Cu in a mounting interface, interface separation, and the growth of Sn whisker (microfiber crystal) in a high-temperature operation test are not described. There is no description about countermeasures of these problems.

In case of using the Sn plating film and a lower base plating film (Ni, Co, Au, Ag, Pt, Pd or Rh), the Sn whisker generates during the manufacturing process or under the customer environment. The Sn whisker is easily generated in an environment test such as temperature cycles especially when the lower base plating film is made of a material such as Ni or Co which is hard and is small in thermal expansion coefficient. This is due to the difference in thermal expansion coefficient between the material and Sn. Therefore, there is a problem in quality on formation of the Sn plating film in case of use of the lower base plating film of this type.

Also, in case of using a Pb-Sn solder plating film and the lower base plating film (Ni, Co, Au, Ag, Pt, Pd or Rh), the Sn-whisker problem can be avoided because the solder plating film contains Pb (lead). However, the semiconductor device is not an environment friendly product due to the presence of Pb.

Even in case of using one of the Sn plating film or a Pb-Sn solder film and the lower base plating film (Ni, Co, Au, Ag, Pt, Pd or Rh), there is a possibility of interface separation because of a high-temperature test of 150 °C for the long period of 1000 hours in an actual operation environment, if a lead-free solder is used in the secondary mounting. For example, when the lead-free solder is used in the secondary mounting in the structure that a Ni plating film having the thickness of 0.1 µm to 0.7 µm is used as the lower base plating film, and the high-temperature test is carried out for 1000 hours in this condition, the diffusion of Sn and Cu advances partially. Thus, it is impossible to avoid the aforementioned separation problem.

### Summary of the Invention

An object of the present invention is to provide a semiconductor device and a method of manufacturing the same, under the lead-free environment.

In an aspect of the present invention, a semiconductor device includes a lead frame having a lower base structure of oxygen free copper or copper-based alloy and having terminals; a semiconductor chip connected with the terminals of the lead frame; and a mold resin configured to cover the semiconductor chip. The lead frame has an exposed portion from the mold resin, and the exposed portion includes a diffusion prevention film formed on or above the lower base structure of the lead frame; and a Sn-Bi (tin-bismuth) film formed on the diffusion prevention film.

Here, the diffusion prevention film may be formed of Ni (nickel), and may have the thickness of 0.8 µm or more.

Also, the Sn-Bi film may contain Bi of 1% or more. When each of the terminals is a lead which is bent, the Sn-Bi film may contain Bi in a range of 1% to 4%.

Also, in another aspect of the present invention, a circuit assembly includes a printed circuit board having circuit patterns; and a semiconductor device described above, provided on the printed circuit board and connected to the circuit patterns through the terminals by solder. The solder is lead-free solder.

Also, the solder may be made of Sn-Ag-Cu (tin-silver-copper). each of the circuit patterns may include a first pattern made of oxygen free copper or copper-based alloy and having terminals; and a second pattern formed of Ni on the first pattern. The circuit pattern may further include a third pattern formed of Sn-Bi on the second pattern.

Also, in another aspect of the present invention, a method of manufacturing a semiconductor device, is achieved by installing a semiconductor chip on a lead frame; by bonding the semiconductor chip to terminals of the lead frame by conductive wires; and by molding the semiconductor chip, the conductive wires and a part of the lead frame. After the molding, the lead frame includes a lower base structure of oxygen free copper or copper-based alloy; a Ni film formed on or above the lower base structure of the lead frame; and a Sn-Bi (tin-bismuth) film formed on the Ni film.

The method may further include plating the Ni film on or above the lower base structure of the lead frame; and plating the Sn-Bi film formed on the Ni film. In this case, the plating the Ni film and the plating the Sn-Bi film may be carried out before the installing, or after the molding.

Also, the diffusion prevention film may have a thickness of 0.8 µm or more. The Sn-Bi film may contain Bi of 1% or more. When each of the terminals is a lead which is bent, the Sn-Bi film may contain Bi in a range of 1% to 4%.

### Brief Description of the Drawings

Fig. 1A is a cross sectional view of a semiconductor device according to a first embodiment of the present invention;
Fig. 1B is a partial expanded view of an outer plating of a lead frame of the semiconductor device in the first embodiment;
Fig. 1C is a cross sectional view of the semiconductor device according to the first embodiment which is secondarily mounted on a printed circuit board;
Fig. 1D is a partial expanded view of the structure of the printed circuit board with the semiconductor device in the first embodiment;
Fig. 2A is a cross sectional view of a semiconductor device according to a second embodiment of the present invention;
Fig. 2B is a partial expanded view of an outer plating of the lead frame of the semiconductor device in the second embodiment;
Fig. 2C is a cross sectional view of the semiconductor device according to the second embodiment which is secondarily mounted on a printed circuit board; and
Fig. 2D is a partial expanded view of the structure of the printed circuit board with the semiconductor device in the second embodiment.

### Description of the Preferred Embodiments

Hereinafter, a semiconductor device of the present invention will be described in detail with reference to the attached drawings.

Conventionally, when a high-temperature operation test is carried out to an assembly of a semiconductor device secondarily mounted on a printed circuit board for 1000 hours, solder peeling is caused between the semiconductor device and the printed circuit board. A solder mounting interface is heated to 150 °C or higher due to the heat from the ambient temperature and the heat generated through the operation of the semiconductor device when this semiconductor device is a high-output device. When the semiconductor device is exposed to the high temperature ambience for a long period, solid-phase diffusion of Sn contained in the solder and Cu in the lead frame is caused in a solder junction interface. As a result of this, the precipitation of brittle Sn-Cu intermetallic compounds (Cu₃Sn and Cu₆Sn₅) is produced. In addition, the diffusion rate is large enough to form Karkendal voids at the high temperature close to a melting point of the solder, thereby causing solder peeling at the solder junction interface in a shorter time. The Karkendal voids may grow into cracks to damage solder junction, thereby causing a failure of the semiconductor device.

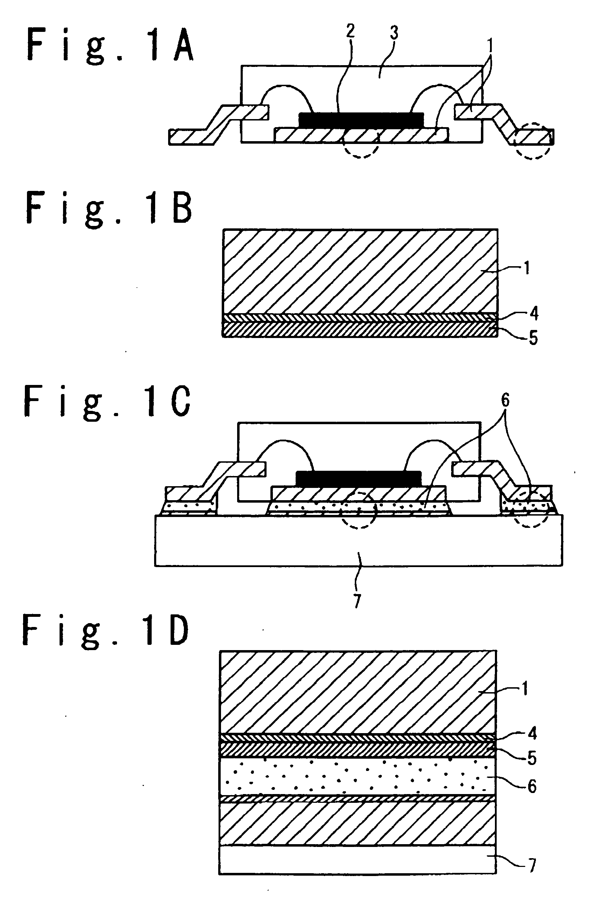

Figs. 1A to 1D show cross sections of the semiconductor device according to the first embodiment of the present invention, and the assembly of the semiconductor device on the printed circuit board. As shown in Fig. 1A, a semiconductor chip 2 is mounted on an island of a lead frame 1 made of oxygen-free copper or copper-based alloy, and then is bonded to leads of the lead frame 1 by gold wires. Subsequently, the semiconductor chip 2, the lead frame 1 with the leads, and the wires are molded by a mold resin 3 for sealing. At this time, a part of each lead and a lower surface of the lead frame 1 are exposed.

Subsequently, outer plating is carried out to the molded semiconductor device. In the outer plating, a Ni (nickel) plating film having the thickness of 0.8 µm or more is applied to a lower base of the lead frame. Thus, the diffusion of Sn and Cu and the interfacial separation can be prevented in the high-temperature operation test for 1000 hours even when the lead-free solder is used in the secondary mounting. Subsequently, Sn-Bi (tin-bismuth) plating is carried out to the lead frame after the Ni plating film to form a surface film and to contain Bi (bismuth) of 1% to 4 wt%. Thus, the Sn whisker growth can be prevented in an environment test such as temperature cycles or heat cycles. Fig. 1B shows the plating result in a portion of the lead or island of the lead frame 1. Thereafter; the lead frame 1 is subjected to a bending process and a cutting process, as well known to a person in the art.

Next, as shown in Fig. 1C, the semiconductor device thus manufactured is secondarily mounted on a printed circuit board 7 using lead-free solder 6 of Sn-Ag-Cu (tin-silver-copper) in a semiconductor maker or in a customer site. Fig. 1D is an expanded view of the solder - board interface.

When the secondary mounting is carried out by using ordinary solder containing Pb (lead), the Pb prevents the diffusion of Sn into Cu. Therefore, there is no problem of the solder separation or solder peeling. On the other hand, when the lead-free solder is used in the secondary mounting, thermal diffusion of Sn into Cu is caused more easily. Therefore, when the assembly of the semiconductor device which is secondarily mounted on the printed circuit board by suing the lead-free solder is located under a high temperature ambience at about 150 °C for a long period, the solid-phase diffusion gradually advances between Sn in the solder and Cu in the lead frame even if the temperature is below the melting point. As a result, the precipitation of the brittle Sn-Cu intermetallic compounds (Cu₃Sn or Cu₆Sn₅) is produced so that solder separation is caused. In addition, the diffusion rate is large enough to form Karkendal voids at the high temperatures close to the melting point of the solder, thereby to cause the solder separation at the solder interface in a shorter time.

In the semiconductor device of the first embodiment, the Ni plating film 4 prevents the solid-phase diffusion between Sn in the solder and Cu in the lead frame, and finally prevents the solder separation. The experiment results of exposure at the high-temperature of about 150°C for the long period of 1000 hours indicate that the Ni plating has the effect of prevention of Sn diffusion when the Ni plating film has the thickness of 0.8 µm or more. Furthermore, Bi has an effect of retardation of Sn whisker growth. Accordingly, the outer plating of the lead frame 1 preferably has a Sn-Bi plating surface layer to prevent the Sn whisker growth in the environmental test such as the temperature cycle. Especially, when a lower plating film of a material is used which is as hard as Ni and has a smaller thermal expansion coefficient than Sn, the Sn whiskers easily grow in the environment test such as temperature cycles due to the difference in thermal expansion coefficient between the material and Sn. Therefore, the Sn-Bi plating film is essential in case of use of the Ni-plating film. Experimental results show that these advantages are realized when Bi is contained in a range of 1% or more. Addition of Bi into Sn makes the plating film hard and brittle. For this reason, when the lead bending process of the lead frame is carried out after the mold resin sealing, as in the first embodiment, it is necessary to control the Bi containing percentage to be 4% or less so as not to cause cracks in the Sn-Bi plating film during the bending process of the lead frame.

As described above, the semiconductor device according to the first embodiment of the present invention is characterized in that the lead frame 1 has the Ni plating film 4 having the thickness of 0.8 µm or more on a base structure, and the Sn-Bi plating film 5 containing Bi of 1 wt% or more on the Ni plating film 4 as the surface layer.

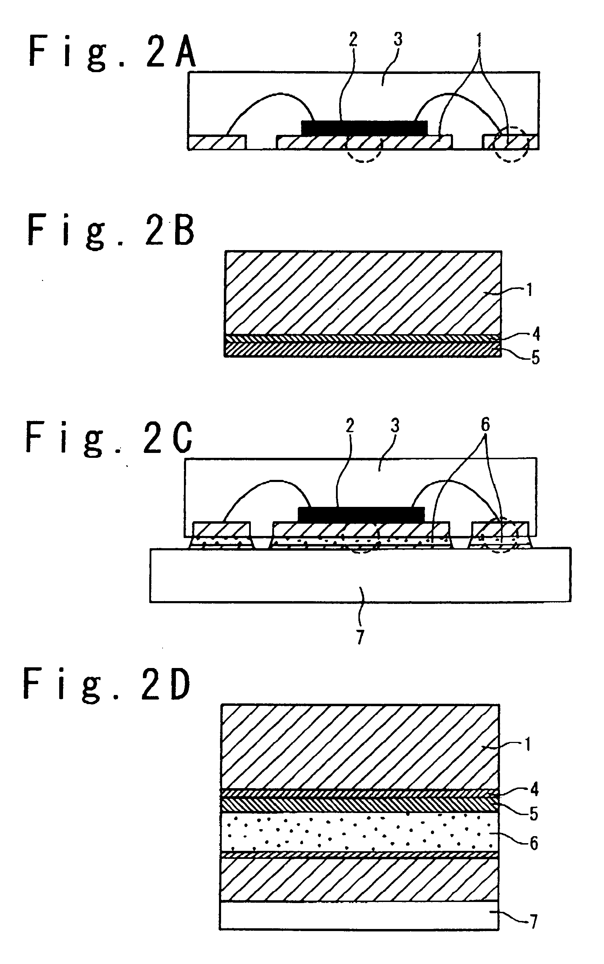

Figs. 2A to 2D show the semiconductor device according to the second embodiment of the present invention, and an assembly of the semiconductor device secondarily mounted on the printed circuit board.

As shown in Fig. 2A, a semiconductor chip 2 is mounted on an island of a lead frame 1 of oxygen-free copper or copper-based alloy, and is bonded to leads of the lead frame 1 by gold wires. Subsequently, the mold resin 3 for sealing is applied to the semiconductor chip 2, and lead frame 1. Subsequently, the molded semiconductor device is subjected to a plating process. For the outer plating of the lead frame 1, the Ni plating film of 0.8 µm or more in thick is applied to the base structure of the lead frame 1, and then the Sn-Bi plating film 5 containing Bi of 1% or more is formed on the Ni plating film as the surface layer. As a result of the plating, the lower surfaces of the leads and island of the lead frame 1 are exposed. This situation is shown in Fig. 2B.

Thereafter, adjacent products are cut off from each other by dicing and formed into individual products. The semiconductor device thus structured is secondarily mounted on the printed circuit board 7 with a copper pattern by using the lead-free solder 6 of Sn-Ag-Cu, in a semiconductor maker or a customer site. As shown in Figs. 2C and 2D, there is no diffusion of Sn and Cu or the interfacial separation at the mounting interface even when the printed circuit board with the semiconductor device is exposed to high temperature ambience of 150 °C or more for the long period of 1000 hours after the semiconductor device is secondarily mounted on the printed circuit board 7 by using the lead-free solder 6. In addition, the surface layer of an Sn-Bi plating film 5 containing Bi of 1% or more can prevent the Sn whisker growth.

In the structure of the second embodiment, the Sn-Bi plating film may have a larger Bi containing percentage than in the first embodiment because the lead frame is not subjected to the lead bending process after the plating so that the Sn-Bi plating does not suffer cracks. Therefore, the second embodiment is advantageous for Sn whisker reduction, when the customer usage environment is severe or the semiconductor device is under large stress due to the structure of the package.

A temperature cycle test of 1000 cycles between -45 to 125 °C was carried out to the printed circuit boards with semiconductor devices which use lead frames made of oxygen-free copper or copper-based alloy, having Sn-Bi plating films of the thicknesses of 5 µm, 8 µm and 20 µm, and contain Bi of 1%, 3% and 5%. The semiconductor device samples were observed with SEM (Scanning Electron Microscope). When the Bi containing percentage was 1 wt%, the Sn whisker grew was observed regardless of any Sn-Bi plating film thickness. However, the samples did not indicate the Sn whisker growth when the Bi containing percentage was 3% or 5%. Therefore, it is necessary that the Bi content is 1% or more, to prevent the generation of the Sn whisker in the above temperature environment.

The bonding carried out after the semiconductor chip 2 is mounted on the lead frame 1 may be wire bonding or wireless bonding. For example, in the semiconductor device of the present invention, when a flip-chip mounted BGA (Ball Grid Array) package is used, the wireless bonding is employed. In this case, a copper thin film or a copper plating film applied on an electrode pad of the semiconductor chip 2 corresponds to the lead frame 1, and bumps such as lead-free solder balls correspond to the lead-free solder 6. The bumps are made of the lead-free material.

Also, the plating may be applied to the copper patterns on the printed circuit board 7 to form an outer plating film on the copper patterns. In this case, the Ni plating film 4 is formed on the copper pattern and the Sn-Bi plating film 5 is formed on the Ni plating film 4 as the surface layer.

As described above, the semiconductor device may be provided as a high-output semiconductor device used in a transmission stage of each communication system. In this case, the semiconductor device is made of the lead-free material in consideration of the environment and has a stable quality at the high temperature of 150 °C or more caused by the operation of the semiconductor device and the ambient environment.

In the above embodiments, the outer plating process may be carried out when the lead frame 1 is produced, not after the molding process.

The semiconductor device of the present invention is manufactured by mounting and bonding the semiconductor chip onto the lead frame made of the oxygen-free copper or the copper-based alloy; applying the mold resin sealing; and then applying the outer plating. For the outer plating of the lead frame, a Ni plating film of 0.8 µm or more in thick is formed on a base structure, and then the Sn-Bi plating film containing Bi of 1% or more is formed on the Ni plating film as the surface layer. The semiconductor device thus structured and used at the temperatures of 150 °C or more is mounted on the printed circuit board by using the lead-free solder.

Furthermore, the semiconductor device of the present invention can also be used as the high-output semiconductor device used as the transmission stage of each of communication systems such as mobile phone base stations, mobile phone terminals and cable TV relay facilities.

## Claims

1. A semiconductor device comprising:
a lead frame having a lower base structure of oxygen free copper or copper-based alloy and having terminals;
a semiconductor chip connected with said terminals of said lead frame; and
a mold resin configured to cover said semiconductor chip,
wherein said lead frame has an exposed portion from said mold resin, and
said exposed portion comprises:
a diffusion prevention film formed on or above the lower base structure of said lead frame; and
a Sn-Bi (tin-bismuth) film formed on said diffusion prevention film.

2. The semiconductor device according to claim 1, wherein said diffusion prevention film is formed of Ni (nickel).

3. The semiconductor device according to claim 1, wherein said diffusion prevention film has a thickness of 0.8 µm or more.

4. The semiconductor device according to any of claims 1 to 3, wherein said Sn-Bi film contains Bi of 1% or more.

5. The semiconductor device according to claim 4, wherein each of said terminals is a lead which is bent, and
said Sn-Bi film contains Bi in a range of 1% to 4%.

6. A circuit assembly comprising:
a printed circuit board having circuit patterns; and
a semiconductor device according to any of claims 1 to 5, provided on said printed circuit board and connected to said circuit patterns through said terminals by solder,
wherein said solder is lead-free solder.

7. The circuit assembly according to claim 6, wherein said solder is made of Sn-Ag-Cu (tin-silver-copper).

8. The circuit assembly according to claim 6 or 7, wherein each of said circuit patterns comprises:
a first pattern made of oxygen free copper or copper-based alloy and having terminals; and
a second pattern formed of Ni on said first pattern.

9. The circuit assembly according to claim 8, wherein said circuit pattern further comprises:
a third pattern formed of Sn-Bi on said second pattern.

10. A method of manufacturing a semiconductor device, comprising:
installing a semiconductor chip on a lead frame;
bonding said semiconductor chip to terminals of said lead frame by conductive wires; and
molding said semiconductor chip, said conductive wires and a part of said lead frame,
wherein after said molding, said lead frame comprises:
a lower base structure of oxygen free copper or copper-based alloy;
a Ni film formed on or above the lower base structure of said lead frame; and
a Sn-Bi (tin-bismuth) film formed on said Ni film.

11. The method according to claim 10, further comprising:
plating said Ni film on or above the lower base structure of said lead frame; and
plating said Sn-Bi film formed on said Ni film.

12. The method according to claim 11, wherein said plating said Ni film and said plating said Sn-Bi film are carried out before said installing.

13. The method according to claim 11, wherein said plating said Ni film and said plating said Sn-Bi film are carried out after said molding.

14. The method according to any of claims 10 to 13, wherein said diffusion prevention film has a thickness of 0.8 µm or more.

15. The method according to any of claims 10 to 14, wherein said Sn-Bi, film contains Bi of 1% or more.

16. The method according to claim 15 wherein each of said terminals is a lead which is bent, and
said Sn-Bi film contains Bi in a range of 1% to 4%.
